(19) **Europäisches Patentamt**

**European Patent Office**

**Office européen des brevets**

(11) Veröffentlichungsnummer: **0 223 137 B1**

# (12) EUROPÄISCHE PATENTSCHRIFT

(45) Veröffentlichungstag der Patentschrift:
**16.01.91 Patentblatt 91/03**

(21) Anmeldenummer: **86115163.7**

(22) Anmeldetag: **31.10.86**

(51) Int. Cl.⁵: **H01L 39/14, H01L 39/24**

(54) Supraleitender Verbundleiter mit mehreren Leiteradern und Verfahren zu dessen Herstellung.

(30) Priorität: **12.11.85 DE 3540070**

(43) Veröffentlichungstag der Anmeldung:
**27.05.87 Patentblatt 87/22**

(45) Bekanntmachung des Hinweises auf die
Patenterteilung:
**16.01.91 Patentblatt 91/03**

(84) Benannte Vertragsstaaten:
**BE CH DE FR GB LI**

(56) Entgegenhaltungen:
**DE-A- 3 430 159**
**FR-A- 1 584 811**

(56) Entgegenhaltungen:
**US-A- 3 714 371**
**IEEE TRANSACTIONS ON MAGNETICS, Band
MAG-19, Nr. 3, Mai 1983, Seiten 672-675, New
York, US; F. IRIE et al.: "An Al-stabilized
Nb3Sn pulse coil"**

(73) Patentinhaber: **Siemens Aktiengesellschaft
Wittelsbacherplatz 2
D-8000 München 2 (DE)**

(72) Erfinder: **Wilhelm, Manfred, Dr. Dipl.-Chem.
Teutonenstrasse 23
D-8500 Nürnberg (DE)**
Erfinder: **Wohlleben, Karl, Dr. Dipl.-Phys.
Markweg 15
D-8520 Erlangen (DE)**

EP 0 223 137 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf einen supraleitenden Verbundleiter mit stabilisierendem Material und mehreren supraleitenden Leiteradern, die aus einer in einer Diffusionsreaktion ausgebildeten intermetallischen Verbindung aus wenigstens zwei Elementen bestehen und in eine Matrix aus normalleitendem Material eingebettet sind, welche von einem Aluminium-Mantel als stabilisieren dem Material umschlossen ist und Kupfer als Legierungspartner von mindestens einem der Elemente der Verbindung enthält, wobei dieses mindestens eine Legierungselement der Matrix durch eine Barriere von dem stabilisierenden Material getrennt ist. Ein derartiger supraleitender Verbundleiter ist z.B. aus "IEEE Transactions on Magnetics", vol. MAG-19, no. 3, Mai 1983, Seiten 672 bis 675 bekannt. Die Erfindung betrifft ferner ein Verfahren zur Herstellung eines solchen supraleitenden Verbundleiters.

Für technische Anwendungen geeignete Supraleiter enthalten neben ihrer supraleitenden Stoffkomponente stets auch eine normalleitende Komponente hoher Leitfähigkeit zur Stabilisierung des supraleitenden Zustandes. Tritt nämlich in einem solchen Leiter lokal eine Temperaturerhöhung auf, etwa als Folge von Flußsprüngen, so wird die Stromtragfähigkeit des Supraleiters im entsprechenden Bereich zwar kleiner oder verschwindet sogar ; jedoch kann dann kurzzeitig von der normalleitende Komponente Strom übernommen werden, so daß der Supraleiter die Möglichkeit hat, sich wieder zu erholen. Dieser Vorgang wird deshalb auch als Stabilisierung gegen transiende Störungen bezeichnet. Mit der stabilisierenden Komponente kann also eine unzulässige Temperaturerhöhung einer aus einem solchen Supraleiter gewickelten Spule bei Ausbreitung der Normalleitungszone und somit eine Zerstörung des Wickelpaketes verhindert werden.

Zur Stabilisierung von Supraleitern wird im allgemeinen hochleitfähiges Kupfer (Cu) verwendet, das bei einer sogenannten Außenstabilisierung den Supraleiter in Form eines Mantels umhüllt oder bei einer sogenannten Innenstabilisierung als mindestens ein Kern im Zentrum des Leiters angeordnet ist. Neben Kupfer gewinnt auch Aluminium (Al) als normalleitende Komponente zur Stabilisierung von Supraleitern zunehmend an Bedeutung. Die Leitfähigkeit von Aluminium verglichen mit der von Kupfer ist nämlich bei 4,2 K bereits im magnetfeldfreien Raum wesentlich höher und nimmt auch im Feld mit steigender Flußdichte erheblich weniger ab als die Leitfähigkeit von Cu. So sind an Proben aus weichgeglühtem Cu 99,997% und weichgeglühtem Al 99,995% bei 4,2 K spezifische Widerstände von $2 \times 10^{-9} \, \Omega \times cm$ bzw. $6 \times 10^{-10} \, \Omega \times cm$ zu messen. Bei 4,2 K und einer magnetischen Flußdichte von 12 Tesla ist der spezifische Widerstand von Kupfer-Proben etwa 26-mal, derjenige von Aluminium-Proben jedoch nur 6-mal größer als im feldfreien Raum.

Entsprechende supraleitende Verbundleiter, deren stromtragende Komponente eine spröde, nicht verformbare intermetallische Verbindung ist, lassen sich insbesondere nach einem besonderen Verfahren, dem sogenannten Bronze-Prozeß, herstellen. Im Falle der intermetallischen Verbindung $Nb_3Sn$ werden hierzu vorgefertigte Verbunddrähte mit den Endabmessungen des gewünschten Leiters, bestehend aus Niobleiteradern bzw. -filamenten in einer Matrix aus Kupfer-Zinn-Bronze, bei einer Temperatur um etwa 700°C eine vorbestimmte Zeit lang geglüht. Im Kupfer gelöstes Zinn, wobei im allgemeinen nur die $\alpha$-Phase dieser Legierung vorgesehen wird, reagiert dabei in einer Feststoffreaktion mit dem Niob zu der gewünschten intermetallischen Verbindung $Nb_3Sn$. Werden nun derartige Bronze-Leiter wie üblich mit Kupfer stabilisiert, so müssen die Bronze der Matrix und das Kupfer des Stabilisierungsquerschnittes durch eine besondere Zwischenschicht z.B. aus Niob oder insbesondere aus Tantal getrennt werden. Solche Metalle wirken dann als Diffusionsbarriere (vgl. z.B. DE-OS 23 39 525) und verhindern während der Reaktionsglühung zur Ausbildung der gewünschten supraleitenden Verbindung das Eindringen von Zinn in das stabilisierende Kupfer und damit eine Herabsetzung dessen elektrischer und thermischer Leitfähigkeit. Bereits so geringe Beimengungen wie 0,05 Gew.-% Zinn reduzieren nämlich das Restwiderstandsverhältnis von Kupfer von rund 1000 auf einen Wert von etwa 20. Mit elektrisch und damit auch thermisch schlecht leitendem Kupfer ist aber kaum eine ausreichende Stabilisierungswirkung auf den supraleitenden Zustand zu erreichen.

Neben Kupfer als Stabilisierungsmaterial von derartigen Verbundsupraleitern wird auch eine Stabilisierung mit Aluminium angestrebt. Hierzu kann das Aluminium nach der Reaktionsglühung auf einen verseilten Leiter mit Hilfe von Blei-Zinn-Lot aufgelötet werden (vgl. "IEEE Transactions on Magnetics", vol. MAG-17, no. 5, September 1981, Seiten 2047 bis 2050).

Man kann auch Verbundleiter aus Bronze und Niobfilamenten mit einem zentralen Kern aus Aluminium herstellen, wobei dieser Kern mit einer Diffusionsbarriere aus Niob umgeben ist (vgl. z.B. ""IEEE Transactions on Magnetics", vol. MAG-21, no. 2, März 1985, Seiten 157 bis 160). Bei diesem Leitertyp muß jedoch die Reaktionsglühung unterhalb des Schmelzpunktes von Aluminium durchgeführt werden.

Ein weiteres Verfahren zur Stabilisierung eines supraleitenden Verbundleiters mit Aluminium geht aus der eingangs genannten Veröffentlichung "IEEE Trans.Magn.", vol. MAG-19 hervor. Gemäß diesem Verfahren wird zunächst ein Leitervorprodukt dadurch hergestellt, daß man eine vorbestimmte Anzahl von Drähten aus dem einen Element der Verbindung, insbesondere Niob-Drähte, in eine Matrix einbettet, die das restliche oder die restlichen Elemente der Verbindung in Form einer Legierung enthält und somit beispielsweise aus einer Zinn-Bronze besteht. Außerdem enthält dieser Aufbau insbesondere an seiner Außenseite noch Kupfer als Stabilisierungsmaterial, das von dem Bronzematerial in bekannter Weise durch diffusionshemmende Barrieren getrennt ist. Nachdem dieser Aufbau auf die gewünschte Endform gearbeitet ist, wird mittels Wärmebehandlung in einer Diffusionsreaktion die gewünschte supraleitende Verbindung wie $Nb_3Sn$ ausgebildet. Dieser so entstandene supraleitende Leiterkern wird schließlich noch durch Strangpressen mit einem Aluminiummantel versehen, wobei sich eine gute metallurgische Bindung zwischen dem Kupfer und dem Aluminium erreichen läßt.

Bei den nach diesem bekannten Verfahren hergestellten supraleitenden Verbundleitern beanspruchen somit die Diffusionsbarrieren einen Teil des normalleitenden Querschnittes, so daß bei diesem Leitertyp die effektive Stromdichte $J_{ov}$ entsprechend begrenzt ist. Dieser Querschnitt kann auch nicht beliebig verkleinert werden, da die als Barrierenmaterial verwendeten Niob- oder Tantal-Rohre bei zu geringer Wandstärke, wie sie sich bei den üblich hohen Verformungsgraden der Rohleiter einstellen würde, zum Aufplatzen neigen.

Aufgabe der vorliegenden Erfindung ist es deshalb, den supraleitenden Verbundleiter der eingangs genannten Art dahingehend auszugestalten, daß er technisch einfach und kostensparend mit Aluminium zu stabilisieren ist, wobei eine möglichst hohe effektive Stromdichte $J_{ov}$ gewährleistet wird.

Diese Aufgabe wird erfindungsgemäß dadurch gelöst, daß die Barriere von der gemeinsamen Grenzschicht zwischen dem Aluminium des Mantels und dem Kupfer der Matrix-Legierung gebildet ist und aus mindestens einer intermetallischen Kupfer-Aluminium-Verbindung besteht. Unter einer Grenzschicht wird dabei auch ein aus mehreren schichtartigen Zonen zusammengesetzter Übergangsbereich zwischen den genannten Metallen verstanden.

Die Erfindung geht von der bekannten Tatsache aus, daß nach der Diffusionsreaktion zur Ausbildung der gewünschten supraleitenden intermetallischen Verbindung das eine Element dieser Verbindung, das zunächst in Form einer Legierung in der Matrix vorhanden war, nicht vollständig aufgebraucht ist, sondern zu einem, wenn auch geringen Anteil noch immer in der Matrix vorhanden ist. Der Erfindung liegt nun die Erkenntnis zugrunde, daß auch ein solches Matrixmaterial unmittelbar mit einem Aluminium-Mantel versehen werden kann, ohne daß die Stabilisierungswirkung in nennenswertem Umfange beeinträchtigt wird. Bei dem Verfahrensschritt des Ummantelns der Matrix mit Aluminium, der bei erhöhter Temperatur durchzuführen ist, bilden sich nämlich durch eine Diffusionsreaktion an der Grenzschicht zwischen dem Kupfer der Legierungsmatrix und dem Aluminium des Mantels im allgemeinen mehrere Cu-Al-Verbindungen aus, die als Barriere für das in der Matrix noch vorhandene Element der supraleitenden Verbindung fungieren. Im Falle einer Zinn-Bronze diffundiert also das noch vorhandene Zinn nicht durch diese Grenzschicht und somit auch nicht in das Aluminium hinein. Die mit der Erfindung erzielten Vorteile sind insbesondere darin zu sehen, daß auf spezielle Diffusionsbarrieren wie z.B. aus Niob oder Tantal verzichtet werden kann und auch eine besondere Kupfer-Außenschicht der Matrix nicht erforderlich ist. Der erfindungsgemäße Supraleiter weist somit einen einfachen Aufbau auf und läßt sich dementsprechend kostengünstig erstellen.

Besonders vorteilhaft ist es, wenn man den erfindungsgemäßen supraleitenden Verbundleiter dadurch herstellt, daß ein Leiterkern mit in die Matrix eingebetteten supraleitenden Leiteradern nach einem sogenannten Bronze-Prozeß ausgebildet wird und dieser Leiterkern anschließend durch Strangpressen bei erhöhter Temperatur mit dem Aluminium-Mantel versehen wird, wobei die Grenzschicht mit entsteht.

Vorteilhafte Ausgestaltungen des erfindungsgemäßen Verbundleiters bzw. des Verfahrens zu seiner Herstellung gehen aus den restlichen Unteransprüchen hervor.

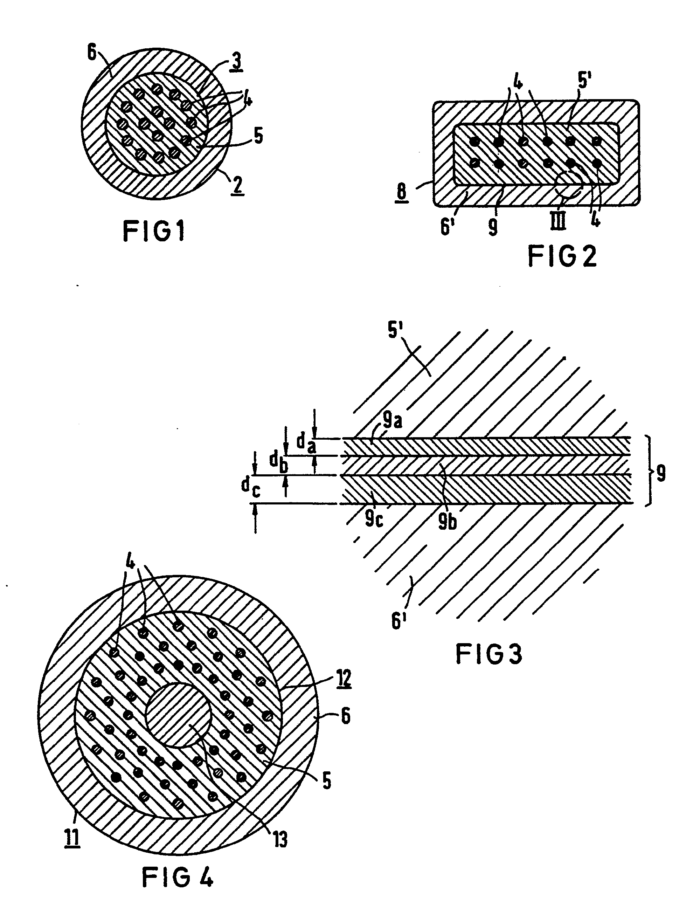

Zur weiteren Erläuterung der Erfindung wird nachfolgend auf die Zeichnung Bezug genommen, in deren Figuren 1 und 2 jeweils ein Querschnitt durch den Aufbau eines erfindungsgemäßen supraleitenden Verbundleiters schematisch veranschaulicht ist. In Figur 3 ist ein Ausschnitt des Verbundleiters nach Figur 2 näher ausgeführt. Figur 4 zeigt schematisch eine weitere Ausführungsform eines Verbundleiters nach der Erfindung. In den Figuren sind gleiche Teile mit den gleichen Bezugszeichen versehen.

Den in den Figuren angedeuteten Ausführungsbeispielen ist die Herstellung von supraleitenden Verbundleitern zugrundegelegt, deren supraleitendes Material jeweils eine aus zwei Komponenten mit jeweils mindestens einem Element bestehende supraleitende intermetallische Verbindung von Typ $A_3B$ ist, die Al5-Kristallstruktur aufweist. Als Material sei die Verbindung $Nb_3Sn$ angenommen, obwohl ebensogut auch andere binäre oder ternäre Verbindungen entsprechend herzustellen sind. Da diese Verbindungen im allgemeinen sehr spröde sind, ist ihre Herstellung in einer beispielsweise für Magnetspulen geeigneten Form schwierig. Zu ihrer Herstellung wird deshalb die sogenannte Bronze-Technik angewandt (vgl. z.B. DE-OS 2 056 779 ; "Cryogenics", Juni 1976, Seiten 323 bis 330 oder "Kerntechnik", 20. Jg., 1978, Heft 6, Seiten 253 bis 261). Dieses bekannte Verfahren dient insbesondere zur Herstellung von sogenannten Vielkernleitern mit in einer normalleitenden Matrix angeordneten Leiteradern, die zumindest Oberflächenschichten aus den genannten Verbindungen aufweisen. Hierzu wird zunächst ein z.B. drahtförmiges duktiles Element der herzustellenden Verbindung mit einer Hülle aus einem duktilen Matrixmaterial, das eine vorbestimmte Menge der übrigen Elemente der herzustellenden Verbindung in Form einer Legierung enthält, umgeben. Es kann auch eine Vielzahl solcher Drähte in die Matrix eingelagert werden. Der so gewonnene Aufbau wird dann einer querschnittsverringernden Bearbeitung unterzogen und in eine vorbestimmte Anzahl von Teilstücken zerschnitten. Diese Teilstücke werden dann gebündelt und wiederum durch eine Querschnittsverminderung in eine langgestreckte Form gebracht. Mit den Querschnittsverminderungen wird der Durchmesser der Drahtkerne auf einen niedrigen Wert in der Größenordnung von einigen μm reduziert. Man erhält so ein noch nicht durchreagiertes Vorprodukt des supraleitenden Verbundleiters in der angenommenen Form eines langen Drahtes, wie er später zum Wickeln von Spulen benötigt wird. Dieses Vorprodukt wird schließlich einer Glühbehandlung unter Vakuum oder in einer Atmosphäre eines inerten Gases wie z.B. Argon unterzogen, wobei das oder die in der Matrix enthaltenen Elemente der zu bildenden supraleitenden Verbindung in das aus dem anderen Element der Verbindung bestehende Material der Drahtkerne eindiffundieren und so mit diesem unter Bildung einer aus der gewünschten supraleitenden Verbindung bestehenden Schicht reagieren.

Gemäß dem Figur 1 zugrundegelegten Ausführungsbeispiel eines Verbundleiters 2 wird so ein Leiterkern 3 mit kreisförmigem Querschnitt erhalten, der eine Vielzahl von supraleitenden Leiteradern bzw. Filamenten 4 enthält, welche in einer Matrix 5 eingebettet sind. Die Leiteradern 4 bestehen dabei zumindest an ihrer Oberfläche aus der intermetallischen Verbindung Nb$_3$Sn. Die Matrix, für die aus Duktilitätsgründen zunächst von einer $\alpha$-Bronze mit maximal etwa 14,5 Gew.-% Zinn ausgegangen wird, weist auch nach der Glühbehandlung zur Ausbildung der supraleitenden intermetallischen Verbindung noch einen Rest an Zinn von einigen Gewichtsprozenten auf; d.h., sie besteht somit nach wie vor aus einer Bronze, wenn auch mit wesentlich vermindertem Zinn-Anteil von beispielsweise 3 Gew.-%. Gemäß der Erfindung ist nun diese Bronze-Matrix 5 mit den eingelagerten Nb$_3$Sn-Leiteradern 4 unter Beibehaltung einer möglichst großen effektiven Stromdichte $J_{ov}$ besonders einfach und auch kostensparend mit Aluminium zu stabilisieren. Hierzu wird der zweckmäßigerweise in monolithischer Form vorliegende Leiterkern 3 nach der Reaktionsglühung bei einer für die Stromtragfähigkeit optimalen Temperatur zwischen etwa 400°C und 550°C, vorzugsweise zwischen etwa 450°C und 500°C, in bekannter Weise durch Strangpressen mit Aluminium ummantelt. Hierbei wird auch das gewünschte Austrittsprofil des Verbundleiters geformt.

Dieses Austrittsprofil kann, abweichend von der Darstellung nach Figur 1, z.B. auch Rechteckform aufweisen. Ein entsprechender Querschnitt eines solchen Rechteckleiters 8 ist in Figur 2 angedeutet. In dieser Figur ist die verformte Matrix mit 5' und der verformte Aluminium-Mantel mit 6' bezeichnet. Dabei ist zwischen diesen Teilen eine Grenzschicht 9 ausgebildet, die als Barriere gegenüber dem Aluminium für den in der Bronze der Matrix 5' noch vorhandenen Zinn-Anteil fungiert. Von dieser Grenzschicht 9 ist in Figur 3 ein Teilstück vergrößert dargestellt.

Der in dieser Figur gezeigte Aufbau der Grenzschicht 9 zwischen der Bronze-Matrix 5' und dem Aluminium-Mantel 6' läßt sich auch durch spezielle Diffusionsversuche im System Bronze/Aluminium gewinnen. Dabei zeigt sich, daß das hohe Restwiderstandsverhältnis von reinem Aluminium praktisch nicht erniedrigt wird, wenn Al aufgepreßt auf Bronze CuSn3 nicht länger als 0,5 Std. bei 500°C geglüht wird. Eine Abnahme der Al-Leitfähigkeit bei dem wesentlich rascher verlaufenden Strangpreßvorgang ist demnach nicht zu befürchten. Eine Bronze mit 3 Gew.-% Zinn (CuSn3) ist dabei angenommen, da diese Konzentration häufig in der Matrixbronze reaktionsgeglühter Nb$_3$Sn-Leiter auftritt. Makroskopische Untersuchungen und Röntgenmikroanalysen von entsprechenden Diffusionsproben zeigen, daß sich an der Phasengrenzen CuSn3/Al auch bei kurzen Glühzeiten bereits wenige μm-dicke Schichten bzw. Zonen verschiedener intermetallischer Cu-Al-Verbindungen bilden. Gemäß Figur 3 setzt sich die nach einer halbstündigen Glühung bei 500°C ausgebildete Grenzschicht 9 zwischen der Matrix 5' und dem Mantel 6' aus drei schichtartigen Zonen 9a, 9b, 9c mit jeweiliger Dicke $d_a$ bzw. $d_b$ bzw. $d_c$ zusammen. Die an die Matrix 5' angrenzende Zone 9a mit einer Dicke $d_a$ von etwa 1 μm besteht dabei aus einer $\delta$-Phase des Systems Cu-Al, während das Material der etwa gleichdicken Zwischenzone 9b eine n-Phase dieses Systems darstellt. Für die an den Al-Mantel 6' angrenzende Zone 9c mit einer Dicke $d_c$ von etwa 1,5 μm läßt sich eine $\vartheta$-Phase des genannten Systems Cu-Al feststellen. Die Phasenbezeichnungen sind dabei entsprechend dem Buch von M.Hansen und K·Anderko : "Constitution auf Binary Alloys", McGraw-Hill Book Comp., New York, 1958, gewählt. Wegen dieser Ausbildung der schichtartigen Zonen 9a bis 9c ist zum einen eine gute Bindung zwischen dem die supraleitenden Leiteradern 4 enthaltenden Material der Matrix 5' und dem stabilisierenden Aluminium-Mantel 6' gewährleistet. Zum anderen zeigt sich deutlich, daß ein Stofftransport ausschließlich durch Wanderung der Kupfer-Atome erfolgt. Dementsprechend wird in der Bronze der Matrix 5' kein Aluminium und umgekehrt in dem Aluminium des Mantels 6' kein Zinn gefunden.

Aufgrund dieser metallurgischen Gegebenheiten lassen sich mit Hilfe des beschriebenen Strangpreßverfahrens vorreagierte $Nb_3Sn$-Supraleiter, die nur aus einer Bronze-Matrix und eingelagerten $Nb_3Sn$-Leiteradern bestehen, ohne Einbau von zusätzlichen Diffusionsbarrieren mit Aluminium stabilisieren. Der Anteil an nicht-supraleitendem Material an der Leiterquerschnittsfläche wird dadurch, anders als bei Stabilisierung durch mit Ta umhülltem Cu, auf ein Minimum beschränkt. Es ergeben sich so entsprechend höhere Werte für die effektive Stromdichte $J_{ov}$.

Bei der Herstellung der in den Figuren 1 bis 3 gezeigten Verbundleiter 2 bzw. 8 wurde von einer Matrix ausgegangen, die eine zumindest weitgehend homogene Zusammensetzung ihrer Bronze aufweist. Besonders vorteilhaft ist es jedoch, wenn man in dieser Matrix zusätzlich noch einzelne Bereiche mit höherem Zinn-Gehalt vorsieht, um so eine Verkürzung der Zinn-Diffusionswege bei der Reaktionsglühung zur Ausbildung der gewünschten supraleitenden Verbindung zu ermöglichen. Ein entsprechendes Ausführungsbeispiel ist dem Verbundleiter zugrundegelegt, der in Figur 4 angedeutet und mit 11 bezeichnet ist. Dieser Verbundleiter entspricht in großen Teilen dem in Figur 1 gezeigten Leiter 2 und weist somit einen kreisförmigen Querschnitt auf, obwohl er ebensogut auch das in Figur 2 gezeigte Profil haben kann. In seinem zentralen, nach der Diffusionsglühung mit einem Aluminium-Mantel 6 versehenen Leiterkern 12 ist jedoch ein Bereich 13 ausgebildet, der aus einem Teilbereich der Bronze-Matrix hervorgegangen ist, welcher vor der Reaktionsglühung mit Zinn (Sn) angefüllt war, dem zweckmäßig einige Gew.-% (im allgemeinen bis etwa 10 Gew.-%) Kupfer (Cu) hinzulegiert sein können. Da während der Glühbehandlung nicht alles Sn aufgebraucht wird, ist auch danach noch ein gewisser Überschuß an Sn(Cu) in dem dargestellten Bereich 13 vorhanden. Statt des einen Bereiches mit Sn-Überschuß lassen sich vorteilhaft auch mehrere über den Querschnitt des Leiterkerns gleichmäßig verteilte Sn(Cu)-Bereiche vorsehen.

Darüber hinaus können, abweichend von den in den Figuren dargestellten Ausführungsbeispielen, selbstverständlich auch Leiterkerne von Verbundleitern mit Aluminium umpreßt werden, in deren Bronze-Matrix neben den eingelagerten supraleitenden Leiteradern noch mit speziellen Diffusionsbarrieren umschlossene Bereiche aus Cu angeordnet sind. An Art und Aufbau der Diffusionsschichten 9a bis 9c zwischen dem äußeren Al-Mantel 6 bzw. 6' und dem angrenzenden Material der Bronze-Matrix 5 bzw. 5' ändert sich praktisch nichts, da das Zinn nicht am Reaktionsgeschehen im Grenzbereich zwischen diesen Materialien teilnimmt. Dies läßt sich auch aus der Tatsache ersehen, daß bei Diffusionsproben, die mehrere Stunden lang bei 500°C geglüht werden, an der Phasengrenzen Bronze/Al sogar ein erheblicher Anstieg der Zinn-Konzentration als Folge der Cu-Abwanderung in das Al zu beobachten ist.

## Ansprüche

1. Supraleitender Verbundleiter mit stabilisierendem Material und mehreren supraleitenden Leiteradern, die aus einer in einer Diffusionsreaktion ausgebildeten intermetallischen Verbindung aus wenigstens zwei Elementen bestehen und in eine aus normalleitende material Matrix eingebettet sind, welche von einem Aluminium-Mantel als stabilisierenden Material um-schlossen ist und Kupfer als Legierungspartner von mindestens einem der Elemente der Verbindung enthält, wobei dieses mindestens eine Legierungselement der Matrix durch eine Barriere von dem stabilisierenden Material getrennt ist, **dadurch gekennzeichnet,** daß die Barriere von der gemeinsamen Grenzschicht (9 bzw. 9a bis 9c) zwischen dem Aluminium des Mantels (6, 6') und dem Kupfer der Matrix-Legierung (5, 5') gebildet ist und aus mindestens einer intermetallischen Kupfer-Aluminium-Verbindung besteht.

2. Verfahren zur Herstellung des supraleitenden Verbundleiters nach Anspruch 1, **dadurch gekennzeichnet,** daß ein Leiterkern (3, 12) mit in die Matrix (5, 5') eingebetteten supraleitenden Leiteradern (4) nach einem sogenannten Bronze-Prozeß ausgebildet wird und dieser Leiterkern (3, 12) anschließend durch Strangpressen bei erhöhter Temperatur mit dem Aluminium-Mantel (6, 6') versehen wird, wobei die Grenzschicht (9 bzw. 9a bis 9c) mit entsteht.

3. Verfahren nach Anspruch 2, **dadurch gekennzeichnet,** daß für den Leiterkern (12) in der Matrix (5) Bereiche (13) mit erhöhtem Gehalt an dem Legierungselement vorgesehen werden.

4. Verfahren nach Anspruch 2 oder 3, **dadurch gekennzeichnet,** daß zur Herstellung von supraleitenden Leiteradern (4) aus der intermetallischen Verbindung $Nb_3Sn$ von einer $\alpha$-Bronze mit einem Zinn-Anteil von maximal etwa 14,5 Gew.-% für die Matrix (5, 5') ausgegangen wird.

5. Verfahren nach den Ansprüchen 3 und 4, **dadurch gekennzeichnet,** daß in der Bronze für die Matrix (5) Bereiche (13) mit Zinn vorgesehen werden, dem bis etwa 10 Gew.-% Kupfer hinzulegiert ist.

6. Verfahren nach einem der Ansprüche 2 bis 5, **dadurch gekennzeichnet,** daß das Strangpressen bei einer Temperatur zwischen 400°C und 550°C, vorzugsweise zwischen 450°C und 500°C vorgenommen wird.

7. Verfahren nach einem der Ansprüche 2 bis 6, **dadurch gekennzeichnet,** daß ein monolithischer Aufbau für den Leiterkern (3, 12) vorgesehen wird.

## Claims

1. Composite superconductor with stabilising material and several superconductive conductor filaments which consist of an intermetallic compound formed in a diffusion reaction from at least two elements and which are embedded in a matrix of normally conductive material which is enclosed by an aluminium jacket as stabilising material and which matrix contains copper as the alloy partner of at least one of the elements of the compound, this at least one alloy element of the matrix being separated by a barrier from the stabilising material, characterised in that the barrier is formed by the common boundary layer (9 or 9a to 9c) between the aluminium of the jacket (6, 6') and the copper of the matrix alloy (5, 5') and consists of at least one intermetallic copper-aluminium compound.

2. Process for the production of the superconductive composite conductor according to claim 1, characterised in that a conductor core (3, 12) is constructed according to a so-called bronze process with superconductive conductor filaments (4) embedded in the matrix (5, 5') and this conductor core (3, 12) is then provided with the aluminium jacket (6, 6') by extrusion at elevated temperature, the boundary layer (9 or 9a to 9c) being concurrently formed.

3. Process according to claim 2, characterised in that regions (13) with an increased content of the alloy element are provided for the conductor core (12) in the matrix (5).

4. Process according to claim 2 or 3, characterised in that to produce superconductive conductor filaments (4) from the intermetallic compound Nb3Sn one starts with an $\alpha$ bronze with a tin content of at the most about 14.5% by weight for the matrix (5, 5').

5. Process according to claims 3 and 4, characterised in that in the bronze for the matrix (5) regions (13) are provided with tin with which up to about 10% by weight of copper are alloyed.

6. Process according to one of claims 2 to 5, characterised in that the extrusion is carried out at a temperature of between 400°C and 550°C, preferably between 450°C and 500°C.

7. Process according to one of claims 2 to 6, characterised in that a monolithic structure is provided for the conductor core (3, 12).

## Revendications

1. Conducteur composite supraconducteur à matériau stabilisateur et à plusieurs brins supraconducteurs qui sont constitués par un composé intermétallique d'au moins deux éléments, formé par une réaction de diffusion et qui sont noyés dans une matrice en un matériau à conduction normale, qui est entourée par une enveloppe en aluminium en tant que matériau stabilisateur et comportant du cuivre comme composant d'alliage d'au moins un des éléments du composé, ledit au moins un des éléments de la matrice étant séparé du matériau stabilisateur par une barrière, caractérisé par le fait que la barrière est formée par la couche limite commune (9 ou 9a à 9c) entre l'aluminium de l'enveloppe (6, 6') et le cuivre de l'alliage de la matrice (5, 5') et est constituée par au moins un composé intermétallique cuivre-aluminium.

2. Procédé pour la fabrication du conducteur composite supraconducteur selon la revendication 1, caractérisé par le fait que l'on forme, suivant le processus dit du bronze, un noyau de conducteurs (3, 12) avec des brins supraconducteurs (4) noyés dans la matrice (5, 5') et que ce noyau de conducteurs (3, 12) est ensuite pourvu d'une enveloppe d'aluminium (6, 6') par un procédé d'extrusion à température élevée, avec formation simultanée de la couche limite (9 ou 9a à 9c).

3. Procédé selon la revendication 2, caractérisé par le fait que pour le noyau de conducteurs (12) on prévoit dans la matrice (5) des zones (13) à teneur élevée en l'élément d'alliage.

4. Procédé selon la revendication 2 ou 3, caractérisa par le fait que pour la fabrication de brins supraconducteurs (4) en le composé intermétallique $Nb_3Sn$, on part d'un bronze... $\alpha$ avec une teneur en étain au maximum égale à environ 14,5% en poids pour la matrice (5, 5').

5. Procédé selon les revendications 3 et 4, caractérisé par le fait que dans le bronze pour la matrice (5), on prévoit des zones (13) avec de l'étain auquel est allié du cuivre jusqu'à environ 10% en poids.

6. Procédé selon l'une des revendications 2 à 5, caractérisé par le fait que l'extrusion est opérée à une température se situant entre 400°C et 550°C, de préférence entre 450°C et 500°C.

7. Procédé selon l'une des revendications 2 à 6, caractérisé par le fait que l'on prévoit une constitution monolithe pour le noyau de conducteurs (3, 12).

FIG 1

FIG 2

FIG 3

FIG 4